# EUROPÄISCHE PATENTANMELDUNG

(11) **EP 3 787 036 A1**
(43) Veröffentlichungstag der Anmeldung: **03.03.2021**
(21) Anmeldenummer: 20193146.6
(22) Anmeldetag: 27.08.2020
(51) Int. Cl.: H01L 31/0216, H01L 31/0224, H01L 31/068

(54) **SOLARZELLE, ZUGEHÖRIGES HERSTELLUNGS- UND BETRIEBSVERFAHREN SOWIE ANORDNUNG MIT EINER SOLARZELLE UND EINER SPANNUNGSQUELLE**

(30) Priorität: 28.08.2019 DE 102019123085
(71) Anmelder: TPMT-TEPIN MICROELECTRONIC TECHNOLOGY LTD. CO., Chengdu, Sichuan 610054 (CN)
(72) Erfinder: HU, Sifu, Chengdu, Sichuan 610054 (CN); HU, Felix, Chengdu, Sichuan 610054 (CN); HU, Jiajie, Chengdu, Sichuan 610054 (CN)
(74) Vertreter: Dr. Gassner & Partner mbB

(57) **Zusammenfassung**

Solarzelle (2), umfassend
- ein Halbleitersubstrat (4) mit einer n-Zone (5) und einer p-Zone (6),
- eine n-zonenseitig auf dem Halbleitersubstrat (4) angeordnete Passivierungsschicht (8),
- eine Extraktionselektrode (9), welche die Passivierungsschicht (8) durchdringt und die n-Zone (5) kontaktiert und
- eine auf der Passivierungsschicht (8) angeordnete Gateelektrode (10), welche mit dem Halbleitersubstrat (4) und der Passivierungsschicht (8) einen Photoschalter ausbildet, der dazu eingerichtet ist, bei einer Bestrahlung der Passivierungsschicht (8) mit Licht (L) in einen nichtlinearen leitenden Zustand zu schalten, wenn zwischen der Gateelektrode (10) und der Extraktionselektrode (9) eine externe Spannung angelegt wird.

## Beschreibung

Die vorliegende Erfindung betrifft eine Solarzelle, ein Verfahren zur Herstellung einer Solarzelle, ein Verfahren zum Betreiben einer Solarzelle sowie eine Anordnung mit einer Solarzelle und einer Spannungsquelle.

Kommerzielle Solarzellen weisen ein Halbleitersubstrat mit einer n-Zone und einer p-Zone auf und können beispielsweise aus einem kristallinen Siliziummaterial gebildet sein. Bei einer Bestrahlung durch Sonnenlicht werden fotogenerierte Ladungsträger in Form von Elektronen und Löchern erzeugt. Dabei entstehen auch sog. heiße Elektronen und heiße Löcher, die sich durch Kollisionen, Streuung und Strahlungsrelaxation innerhalb von 1 bis 10 ps auf eine Umgebungstemperatur abkühlen. Diese heißen Ladungsträger stehen bei konventionellen Solarzellen nicht für eine Umwandlung in elektrische Energie zur Verfügung. Dadurch ist der Wirkungsgrad konventioneller Solarzellen in der Praxis auf ca. 20 bis 25 % beschränkt.

Der Erfindung liegt die Aufgabe zugrunde, eine demgegenüber verbesserte Möglichkeit zur photovoltaischen Energiewandlung anzugeben.

Zur Lösung dieser Aufgabe wird erfindungsgemäß eine Solarzelle vorgeschlagen, umfassend ein Halbleitersubstrat mit einer n-Zone und einer p-Zone; eine n-zonenseitig auf dem Halbleitersubstrat angeordnete Passivierungsschicht; eine Extraktionselektrode, welche die Passivierungsschicht durchdringt und die n-Zone kontaktiert, und eine auf der Passivierungsschicht angeordnete Gateelektrode, welche mit dem Halbleitersubstrat und der Passivierungsschicht einen Photoschalter ausbildet, der dazu eingerichtet ist, bei einer Bestrahlung der Passivierungsschicht mit Licht in einen nichtlinearen leitenden Zustand zu schalten, wenn zwischen der Gateelektrode und der Extraktionselektrode eine externe Spannung angelegt wird.

Die Erfindung beruht auf der Überlegung, heiße Ladungsträger zu extrahieren, bevor diese auf eine Umgebungstemperatur abgekühlt sind, um die heißen Ladungsträger mit überschüssiger kinetischer Energie in elektrische Energie umzuwandeln. Der Photoschalter beschleunigt dazu die Extraktion heißer Ladungsträger und reduziert den Verlust von überschüssiger Wärmeenergie, die durch Kollisionen der heißen Ladungsträger verursacht wird, weil diese durch das von der externen Spannung erzeugte elektrische Feld von einer ungeordneten thermischen Diffusionsbewegung in eine Driftbewegung übergehen. Im nichtlinear leitenden Zustand führt die Kollision heißer Ladungsträger und einem Gitter des Halbleitersubstrats zu einem neuen Elektronen-Loch-Paar, was einen Ausgangstrom der Solarzelle aufgrund der Stoßionisation erhöht.

Vorteilhafterweise kann mit der erfindungsgemäßen Solarzelle ein wesentlich höherer Wirkungsgrad im Vergleich zu den eingangs genannten konventionellen Solarzellen, bei denen die heißen Ladungsträger in elektrische Energie gewandelt werden, realisiert werden.

Der Photoschalter wird typischerweise durch eine vertikale Struktur ausgebildet, die zumindest die n-Zone, die Passivierungsschicht und ein Material der Gateelektrode umfasst. Typischerweise ist die Gateelektrode aus Silber gebildet. Das Halbleitersubstrat ist typischerweise auf Basis von kristallinem Silizium gebildet. Das Halbleitersubstrat hat typischerweise eine rechteckige Grundfläche mit Seitenlängen zwischen 1 cm und 16 cm. Bevorzugt ist die Grundfläche quadratisch.

Es wird bevorzugt, wenn der Photoschalter dazu eingerichtet ist, seinen flächenbezogenen Widerstand beim Übergang von einem nicht mit Licht bestrahlten Zustand in den nichtlinear leitenden Zustand um einen Faktor zwischen 300 und 4000 zu verringern. Typischerweise liegt der flächenbezogene Widerstand des Fotoschalters im nichtleitenden Zustand bei über 2000 Ω·cm⁻² und im nichtlinearen leitenden Zustand zwischen 0,5 und 3 Ω·cm⁻².

Besonders bevorzugt ist bei der erfindungsgemäßen Solarzelle vorgesehen, dass die Gateelektrode einen die Passivierungsschicht kontaktierenden Hauptabschnitt und ein oder mehrere vom Hauptabschnitt abstehende, die Passivierungsschicht nicht kontaktierende Verbindungsabschnitte aufweist, wobei von dem oder einem jeweiligen Verbindungsabschnitt ein oder mehrere die Passivierungsschicht kontaktierende Nebenabschnitte abstehen. So wird die den Photoschalter ausbildende vertikale Struktur an einer Vielzahl von Stellen über die Solarzelle verteilt ausgebildet.

Dabei wird es bevorzugt, wenn die Verbindungabschnitte an zwei gegenüberliegenden Seiten des Hauptabschnitts ausgebildet sind.

Es ist ferner zweckmäßig, wenn das Halbleitersubstrat eine auf der n-Zone ausgebildete Isolierschicht, insbesondere aus Siliziumdioxid, aufweist. Die Isolierschicht weist bevorzugt eine Dicke zwischen 5 und 10 nm auf. So wird ein ultradünner Isolierfilm realisiert. Die Isolierschicht bildet auch den Photoschalter aus.

Bevorzugt ist die Passivierungsschicht als hydrogenisierte SiNx-Schicht ausgebildet. Dadurch wird eine Si-SiNx-Dünnfilmquantenverbindung realisiert, wobei eine Energiebrandbreite von weniger als 10 meV realisiert wird.

Besonders bevorzugt ist ein flächenbezogener Wasserstoffgehalt in Bereichen der SiNx-Schicht, die zwischen einem von der Gateelektrode kontaktierten Bereich und dem Halbleitersubstrat liegen, wenigstens um den Faktor 10, bevorzugt um den Faktor 100, höher als in übrigen Bereichen der SiNx-Schicht. So wird um die Gateelektrode herum eine ein hoher Transmissionsgrad und eine geringe Wärmeleitfähigkeit mit einem graduell vergrößerten Brechungsindex realisiert.

Es ist bei der erfindungsgemäßen Solarzelle bevorzugt ferner vorgesehen, dass die Passivierungsschicht auf einer vom Halbleitersubstrat abgewandten Seite konkav ausgebildet ist. Typischerweise beträgt die Dicke der Passivierungsschicht an ihrer dünnsten Stelle wenigstens 800 Å, insbesondere wenigstens 1500 Å, und/oder und an ihrer dicksten Stelle, insbesondere an ihrem äußersten Rand, höchstens 3000 Å, insbesondere höchstens 1 µm. Die konkave Ausbildung lässt sich an einem mehrfarbigen Glanz der Solarzelle aufgrund von optischen Interferenzeffekten erkennen.

Darüber hinaus kann die erfindungsgemäße Solarzelle eine Transferelektrode, die die Passivierungsschicht durchdringt und die n-Zone kontaktiert, aufweisen. Zweckmäßigerweise ist die Transferelektrode zwischen der Extraktionselektrode und der Gateelektrode angeordnet. Außerdem kann die erfindungsgemäße Solarzelle eine mit der p-Zone kontaktierte Rückseitenelektrode aufweisen. Die Rückseitenelektrode kann aus einem hochdotierten p-leitenden Material gebildet sein.

Die der Erfindung zugrunde liegende Aufgabe wird ferner gelöst durch ein Verfahren zur Herstellung einer Solarzelle, umfassend folgende Schritte:
- Bereitstellen eines Halbleitersubstrats mit einer n-Zone und einer p-Zone;
- Ausbilden einer Passivierungsschicht und einer Extraktionselektrode, welche die Passivierungsschicht durchdringt und die n-Zone kontaktiert, auf dem Halbleitersubstrat; und
- Ausbilden eines durch die Passivierungsschicht, einer auf der Passivierungsschicht anordneten Gateelektrode und dem Halbleitersubstrat gebildeten Photoschalters, der dazu eingerichtet ist, bei einer Bestrahlung der Passivierungsschicht mit Licht in einen nichtlinearen leitenden Zustand zu schalten, wenn zwischen der Gateelektrode und der Extraktionselektrode eine externe Spannung angelegt wird.

Das Ausbilden des Photoschalters kann ein Ausbilden einer Gateelektrode auf der Passivierungsschicht umfassen.

Ferner kann das Ausbilden des Photoschalters ein Bestrahlen der Passivierungsschicht mittels eines gepulsten Lasers umfassen. Es wird bevorzugt, wenn ein Laser mit einer Strahlbreite zwischen 1 und 3 mm und/oder einer Strahllänge zwischen 1 und 5 cm und/oder einer rechteckigen Strahlform und/oder einer Wellenlänge zwischen 500 und 550 nm und/oder einer Energiedichte zwischen 100 und 300 mJ·cm⁻² und/oder einer Pulsweite zwischen 6 und 18 ns und/oder einer Abtastgeschwindigkeit zwischen 0,1 und 0,5 mm·s⁻¹ verwendet wird.

Das erfindungsgemäße Herstellungsverfahren kann einen Schritt des Ausbildens einer Isolierschicht, insbesondere aus Siliziumdioxid, unmittelbar auf der n-Zone umfassen.

Alternativ oder zusätzlich kann die Passivierungsschicht die Passivierungsschicht als hydrogenisierte SiNx-Schicht ausgebildet werden.

Das Ausbilden der Passivierungsschicht erfolgt bevorzugt durch plasmaunterstützte chemische Gasphasenabscheidung (PECVD). Besonders bevorzugt werden während der plasmaunterstützten chemischen Gasphasenabscheidung stickstoffverdünntes Monosilan und Ammoniak als Arbeitsgase, insbesondere mit einem Strömungsverhältnis zwischen 1:2 und 1:5, verwendet. Ferner kann das Halbleitersubstrat auf 100 °C bis 300 °C erwärmt werden und/oder eine HF-Leistung zwischen 50 und 200 Watt verwendet werden. Das Monosilan kann in 5-bis 15-prozentiger Verdünnung im Stickstoff vorliegen.

Während der plasmaunterstützten chemischen Gasphasenabscheidung kann ein Arbeitsdruck zwischen 20 und 50 Pa verwendet werden. Dies ermöglicht ein schnelles Ausbilden der SiNx-Schicht. Alternativ kann vorgesehen sein, dass während der plasmaunterstützten chemischen Gasphasenabscheidung kann ein Arbeitsdruck zwischen 5 und 10 mTorr verwendet wird. Bei der Verwendung eines solchen Niederdruckverfahrens kann die SiNx-Schicht langsam ausgebildet werden.

Zudem kann bei dem erfindungsgemäßen Herstellungsverfahren, insbesondere beim Ausbilden der Passivierungsschicht und der Extraktionselektrode, zusätzlich eine die Passivierungsschicht durchdringende und die n-Zone kontaktierende Transferelektrode ausgebildet werden.

Das Ausbilden der Gateelektrode und/oder der Extraktionselektrode und/oder der Transferelektrode erfolgt insbesondere durch Siebdrucken. Dabei kann eine Aufschlämmungsschicht auf die für die Elektrode vorgesehenen Bereiche der Passivierungssicht bzw. des Halbleitersubstrats aufgebracht werden. Bevorzugt wird die Aufschlämmungsschicht getrocknet und/oder einer Wärmebehandlung unterzogen.

Die der Erfindung zugrunde liegende Aufgabe wird außerdem gelöst durch ein Verfahren zum Betreiben der erfindungsgemäßen Solarzelle oder einer durch das erfindungsgemäße Herstellungsverfahren erhaltenen Solarzelle, wobei zwischen der Gateelektrode und Extraktionselektrode eine, insbesondere positive, externe Spannung angelegt wird. Typischerweise beträgt die externe Spannung zwischen 2 und 6 Volt.

Die der Erfindung zugrunde liegende Aufgabe wird schließlich gelöst durch eine Anordnung mit einer erfindungsgemäßen Solarzelle oder einer durch das erfindungsgemäße Herstellungsverfahren erhaltenen Solarzelle und mit einer Spannungsquelle, die zur Bereitstellung der externen Spannung an die Gateelektrode und an die Extraktionselektrode angeschlossen ist.

Sämtliche Ausführungen zur zuvor beschriebenen Solarzelle lassen sich analog auf das erfindungsgemäße Herstellungsverfahren und das erfindungsgemäße Betriebsverfahren übertragen, sodass auch mit diesen die hinsichtlich der Solarzelle beschriebenen Vorteile erzielt werden können.

Weitere Vorteile und Einzelheiten der vorliegenden Erfindung ergeben sich aus den im folgenden beschriebenen Ausführungsbeispielen sowie anhand der Zeichnungen. Diese sind schematische Darstellungen und zeigen:
- Fig. 1: eine Prinzipskizze einer geschnittenen Darstellung eines Ausführungsbeispiels der erfindungsgemäßen Anordnung mit einem Ausführungsbeispiel der erfindungsgemäßen Solarzelle;
- Fig. 2: eine Prinzipskizze einer Draufsicht auf das Ausführungsbeispiel der Solarzelle;
- Fig. 3: ein Flussdiagramm eines Ausführungsbeispiel des erfindungsgemäßen Herstellungsverfahrens; und
- Fig. 4: eine experimentell ermittelte Strom-Spannungs-Kennlinie eines Ausführungsbeispiels der Anordnung im Betrieb.

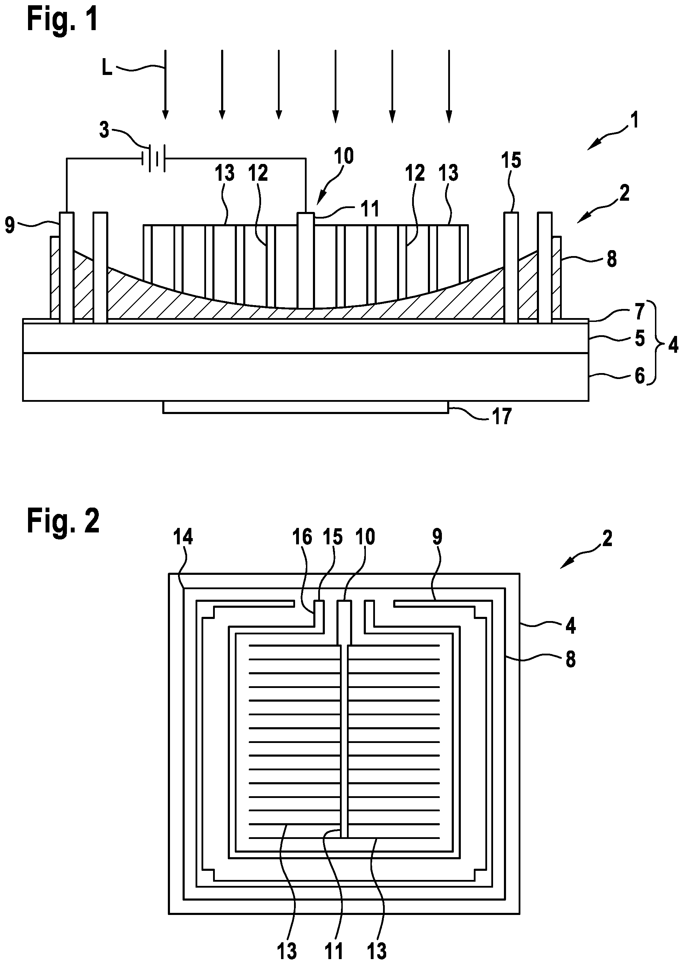

Fig. 1 ist eine Prinzipskizze in einer geschnittenen Darstellung eines Ausführungsbeispiels einer Anordnung 1 mit einem Ausführungsbeispiel einer Solarzelle 2 und mit einer Spannungsquelle 3

Die Solarzelle 2 umfasst ein Halbleitersubstrat 4 auf Basis von kristallinem Silizium mit einer hochdotierten n-Zone 5 und einer p-Zone 6 sowie einer unmittelbar auf der n-Zone 5 angeordneten ultradünnen Isolierschicht 7 mit einer Dicke zwischen 5 und 10 nm. Auf dem Halbleitersubstrat 4 ist n-zonenseitig eine Passivierungsschicht 8 angeordnet. Daneben umfasst die Solarzelle 2 eine Extraktionselektrode 9, welche die Passivierungsschicht 8 durchdringt und die n-Zone 5 kontaktiert. Auf der Passivierungsschicht 8 ist eine Gateelektrode 10 angeordnet.

Die Gateelektrode 10 ist vorliegend aus Silber gebildet und bildet mit dem Halbleitersubstrat 4, konkret mit der n-Zone 5 sowie der Isolierschicht 7, und der Passivierungsschicht 8 einen Photoschalter in einer vertikalen Struktur aus, wobei die n-Zone 5 die Kathode des Photoschalters und die Gateelektrode 10 die Anode bildet. Der Photoschalter ist dazu eingerichtet, bei einer Bestrahlung der Passivierungsschicht 8 mit Licht L im Sonnenspektrum (beispielsweise unter Zugrundlegung eines Luftmassenkoeffizienten der Klasse AM1.5) in einen nichtlinear leitenden Zustand zu schalten, wenn zwischen der Gateelektrode 10 und der Extraktionselektrode 9 eine von der Spannungsquelle 3 bereitgestellte externe Spannung von 2 bis 6 Volt angelegt wird.

Die Gateelektrode 10 weist einen die Passivierungsschicht 8 kontaktierenden Hauptabschnitt 11 und dessen zu beiden Seiten Nebenabschnitte 12 auf, die ebenfalls die Passivierungsschicht 8 kontaktieren. Der Hauptabschnitt 11 und die Nebenabschnitte 12 erstrecken sich senkrecht zur n-Zone 5. Gruppen von Nebenabschnitten 12 sind jeweils mittels eines Verbindungsabschnitts 13, der senkrecht vom Hauptabschnitt 11 absteht (vgl. Fig. 2), mit dem Hauptabschnitt 11 verbunden. Ein solches Design kann auch als Fischflossenstruktur bezeichnet werden.

Die Passivierungsschicht 8 ist als hydrogenisierte SiNx-Schicht ausgebildet. Ihr flächenbezogener Wasserstoffgehalt in Bereichen, die zwischen einem von der Gateelektrode 10 kontaktierten Bereich und dem Halbleitersubstrat 4 liegen, beträgt wenigstens 2·10¹⁸ cm⁻². So wird ein Übergang in Form eines makroskopischen Quantensystem (MQS) des Photoschalters mit einer Bandlücke von weniger als 10 meV gebildet. Der flächenbezogene Wasserstoffgehalt der SiNx-Schicht beträgt außerhalb dieser Bereiche weniger als 2·10¹⁶ cm⁻² und es sind siliziumreiche Quantenpunkte vorhanden. Dadurch wird ein hoher Transmissionsgrad, eine geringe Wärmeleitfähigkeit und ein passivierter Schutzfilm realisiert.

Auf ihrer vom Halbleitersubstrat 4 abgewandten Seite ist die Passivierungsschicht 8 konzentrisch konkav mit einem gestuften, im Wesentlichen parabolischen Profil ausgebildet. Daraus ergibt sich mehrfarbiger Glanz bei der Bestrahlung mit dem Licht L aufgrund von optischen Interferenzeffekten. Die Dicke der Passivierungsschicht 8 beträgt an der dünnsten Stelle zwischen 800 Å und 1500 Å und an der dicksten Stelle, also an Randpunkten 14 (siehe Fig. 2) zwischen 3000 Å und 1 µm. Der Photoschalter kann insofern auch als SiNx-Dünnfilmschalter aufgefasst werden.

Im nichtlinearen leitenden Zustand weist der Photoschalter einen flächenbezogenen Widerstand zwischen 0,5 und 3 Ω·cm⁻² auf. Im nicht mit dem Licht L bestrahlten Zustand beträgt der flächenbezogene Widerstand zwischen 500 und 2000 Ω·cm⁻² bei einer Durchbruchfeldstärke von 3·10⁵ V·cm⁻¹.

Daneben weist die Solarzelle 2 eine zwischen der Extraktionselektrode 9 und der Gateelektrode 10 angeordnete, die Passivierungsschicht 8 durchdringende und die n-Zone 5 kontaktierende Transferelektrode 15 auf. Die Extraktionselektrode 9 und die Transferelektrode 15 sind ebenfalls aus Silber gebildet und weisen eine rechteckige Form auf, wobei an Enden der Transferelektrode 15 zudem von der rechteckigen Form abstehende Verbindungsabschnitte 16 ausgebildet sind.

Ferner ist eine die p-Zone kontaktierende, Rückseitenelektrode 17 aus einem hochdotierten p-leitenden Material vorgesehen.

Bei einer externen Spannung von 0 V stellt die Solarzelle 2 bei der Bestrahlung mit dem Licht L eine Leerlaufspannung zwischen der Extraktionselektrode 9 und der Rückseitenelektrode 17 von rund 0,5 bis 0,7 V bereit. Eine Extraktion heißer Ladungsträger, die durch das Licht L angeregt werden, in Form von heißen Elektronen und heißen Löcher in MQS-Quantenübergangspaaren ist eingeschränkt. Auch wenn die externe Spannung 2 bis 6 Volt beträgt, aber keine Bestrahlung mit dem Licht L erfolgt, ist die Funktion des MQS-Übergangs eingeschränkt. Über der Extraktionselektrode 9 und der Rückseitenelektrode 17 kann dann eine Leerlaufspannung von unter 1,2 V abgegriffen werden.

Bei der Bestrahlung mit dem Licht L und einem Wert der externen Spannung zwischen 2 und 6 Volt geht der Photoschalter bzw. der MQS-Übergang jedoch in den nichtlinear leitenden Zustand über und ermöglicht eine schnelle Selektion und Extraktion heißer Elektronen im Subpikosekundenbereich. Unter dem Einfluss des elektrischen Felds wird die Beweglichkeit der heißen Ladungsträger erheblich erhöht. Die heißen Ladungsträger gehen von einer unkontrollierten thermischen Diffusionsbewegung zu einer Driftbewegung über. Dadurch sinken auch Rekombinationsverluste und Verluste durch überschüssige Wärmeenergie, die durch Kollisionen der heißen Ladungsträger verursacht wird. In diesem Zustand kann die Leerlaufspannung der Solarzelle 2 um den Faktor 2 bis 5 erhöht werden.

Das durch die externe Spannung erzeugte elektrische Feld versursacht eine Stoßionisation der Elektronen zwischen der Passivierungsschicht 8 und dem Halbleitersubstrat 4. Dadurch kann ein Kurzschlussstrom der Solarzelle 2 im Vergleich zu konventionellen Solarzellen ohne Photoschalter um bis zu 30 % erhöht werden.

Bezüglich des AM1.5-Spektrum des Lichts L kann ein Wirkungsgrad der den Photoschalter aufweisenden Solarzelle 2 von mehr als 32 % erzielt werden. Dabei ist zu beachten, dass die Verlustleistung durch das Anlegen der externen Spannung lediglich in der Größenordnung von 5 bis 10 % der maximalen Ausgangsleistung der Solarzelle 2 liegt.

Befindet der Photoschalter im nichtlinear leitenden Zustand, werden durch die Bestrahlung des im Halbleitersubstrat 4 vorhandenen pn-Übergangs mit dem Licht L freie Elektronen in der n-Zone 5 in eine Kathode des Photoschalters injiziert, wodurch eine Elektroneninjektionsquelle gebildet wird. Die externe Spannung kann dann auch unter 2 V gesenkt werden und der nichtlinear leitende Zustand wird aufrechterhalten.

Experimentell konnten für Solarzellen 2 gemäß dem beschriebenen Ausführungsbeispiel folgende Betriebsparameter gemessen werden, wobei V_{L} den Wert der externen Spannung, V₀ die Leerlaufspannung und j₀ eine Ausgangsstromdicht beschreiben:

| | | |
|---|---|---|
| V_{L} = 0 V, AM1,5-Bestrahlung: | V₀ = 0,5 ... 0,7 V | j₀ = 1...3 mA·cm⁻² |
| V_{L} = 4 V, kein Licht: | V₀ = 0,8 ... 1,2 V | j₀ = 5...10 mA·cm⁻² |
| V_{L} = 4 V, AM1,5-Bestrahlung: | V₀ = 3,0 ... 3,5 V | j₀ = 40...48 mA·cm⁻² |

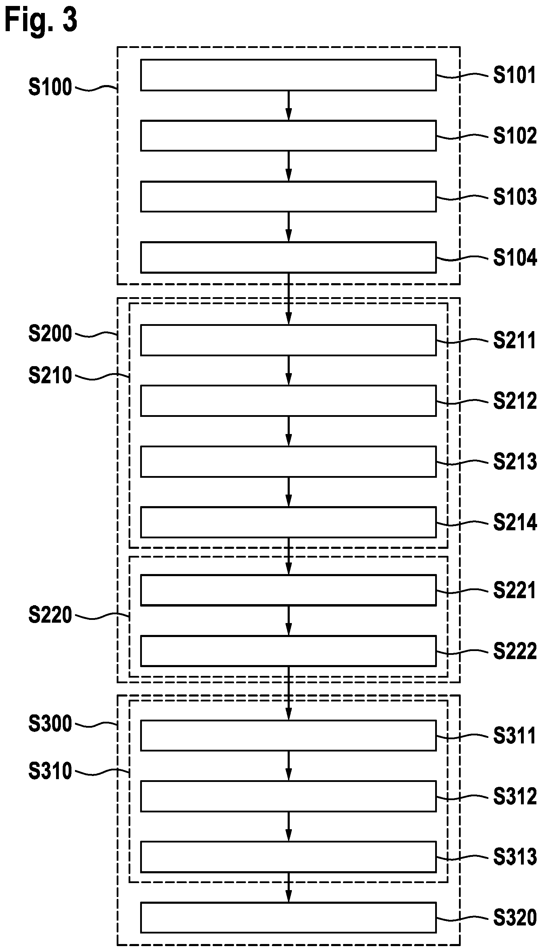

Fig. 3 ist ein Flussdiagramm eines Ausführungsbeispiels eines Verfahrens zur Herstellung einer Solarzelle. Im Rahmen der folgenden Erläuterung des Ausführungsbeispiels werden für einzelne Komponenten der Solarzelle die Bezugszeichen der Fig. 1 und 2 für identische oder gleichwertige Komponenten verwendet.

Ein Schritt S100 des Bereitstellens eines Halbleitersubstrats 4 umfasst Schritte S101 bis S104. Im Schritt S101 wird ein Chip auf Basis von kristallinem Silizium mit einer hochdotierten n-Zone 5 und einer p-Zone 6 bereitgestellt, wobei die Zonen 5, 6 einen pn-Übergang ausbilden. Der Chip hat eine quadratische Grundfläche mit einer Seitenlänge zwischen 1 und 16 cm, hier 12 cm. Im Schritt S102 wird der Chip gereinigt. Im Schritt S103 wird der gereinigte Chip getrocknet. Dies erfolgt unter Reinraumbedingungen bei einer Temperatur von 100 °C für eine Dauer von 30 min. Im Schritt S104 wird eine Isolierschicht 7 auf einer Oberfläche der n-Zone 5 ausgebildet. Die Isolierschicht 7 hat eine Dicke zwischen 5 und 10 nm und wird aus Siliziumdioxid gebildet.

In einem an den Schritt S100 anschließenden Schritt S200 werden eine Passivierungsschicht 8 sowie eine Extraktionselektrode 9 und eine Transferelektrode 15, welche die Passivierungsschicht 8 durchdringen und die n-Zone 5 kontaktieren, ausgebildet. Der Schritt S200 umfasst dabei einen Schritt S210 des Ausbildens der Extraktionselektrode 9 und der Transferelektrode 15, und einen Schritt S220 des Ausbildens der Passivierungsschicht 8.

Der Schritt S210 umfasst wiederum Schritte S211 bis S214. Im Schritt S211 wird durch Siebdrucken eine Aufschlämmungsschicht mit Silber auf den für die Extraktionselektrode 9 vorgesehenen Bereich des Halbleitersubstrats 4 aufgebracht. Analog dazu wird im Schritt S212 durch Siebdrucken eine Aufschlämmungsschicht mit Silber auf den für die Transferelektrode 15 vorgesehenen Bereich des Halbleitersubstrats 4 aufgebracht. Die Aufschlämmungsschichten haben jeweils eine Dicke von 1530 µm. Die Elektroden werden jeweils quadratisch mit einer Breite von 1,5 mm geformt. Der Bereich für die Transferelektrode 15 liegt innerhalb des Bereichs für die Extraktionselektrode 9 und ist 5 bis 8 mm von diesem beabstandet. Die Schritte S211 und S212 können parallel oder in umgekehrter Reihenfolge durchgeführt werden. Im Schritt S213 werden die Aufschlämmungsschichten getrocknet. Dies erfolgt bei einer Temperatur von 100 °C für 30 min. In einem anschließenden Schritt S214 wird eine Wärmebehandlung des Halbleitersubstrats 4 durchgeführt. Dies erfolgt in einer Stickstoffatmosphäre bei einer Temperatur zwischen 250 °C und 400 °C für 5 bis 10 min. Dadurch werden die Extraktionselektrode 9 und Transferelektrode 15 die n-Zone 5 kontaktierend auf dem Halbleitersubstrat 4 ausgebildet.

Der an den Schritt S210 anschließende Schritt S220 des Ausbildens der Passivierungsschicht 8 umfasst seinerseits Schritte S221 und S222. Im Schritt S221 wird das Halbleitersubstrat 4 auf einer Isolierplatte aus Quarz angeordnet und in einen Vakuumraum einer Vorrichtung zur plasmaunterstützten chemischen Gasphasenabscheidung positioniert. Im Schritt S222 wird die Passivierungsschicht 8 als die Extraktionselektrode 9 und die Transferelektrode 15 einfassende SiNx-Schicht durch plasmaunterstützte chemische Gasphasenabscheidung (PECVD) ausgebildet. Dazu wird das Halbleitersubstrat 4 auf 100 °C bis 300°C, hier 200 °C, erwärmt. Als Arbeitsgase werden stickstoffverdünntes Monosilan und Ammoniak in einem Verhältnis zwischen 1:2 und 1:5, hier 1:3, verwendet, wobei das Monosilan in einer 10-prozentigen Verdünnung in Stickstoff vorliegt. Ein Arbeitsdruck der PECVD beträgt 30 Pa bei einer HF-Leistung zwischen 50 und 200 W, hier 70 W, mit einer Frequenz von 13,56 MHz. Die PECVD wird für eine Dauer von 20 min durchgeführt. Dabei wird die Passivierungsschicht 8 schichtweise ausgebildet, sodass die Dicke der Passivierungsschicht 8 mittig 900 Å beträgt und stufenweise auf eine Dicke von 4500 Å an ihrem äußersten Rand ansteigt. Die Passivierungsschicht 8 wird folglich konkav ausgebildet.

An den Schritt S200 schließt sich ein Schritt S300 des Ausbildens eines durch die Passivierungsschicht 8, einer auf der Passivierungsschicht 8 anordneten Gateelektrode 10 und dem Halbleitersubstrat 4 gebildeten Photoschalters an, der dazu eingerichtet ist, bei einer Bestrahlung der Passivierungsschicht 8 mit Licht L in einen nichtlinearen leitenden Zustand zu schalten, wenn zwischen der Gateelektrode und der Extraktionselektrode eine externe Spannung angelegt wird. Der Schritt S300 umfasst einen Schritt S310 und einen Schritt S320.

Im Schritt S310 wird zunächst die Gateelektrode 10 auf der Passivierungsschicht 8 ausgebildet, was wiederum Schritte S311 bis S313 umfasst. Im Schritt S311 wird durch Siebdrucken eine Aufschlämmungsschicht mit Silber auf den für die Gateelektrode 10 vorgesehenen Bereichen der Passivierungsschicht 4 aufgebracht. Dies erfolgt derart, dass die Gateelektrode 10 einen die Passivierungsschicht 8 kontaktierenden Hauptabschnitt 11 und zu dessen beiden Seiten Nebenabschnitte 12 erhält, die ebenfalls die Passivierungsschicht 8 kontaktieren. Der Hauptabschnitt 11 und die Nebenabschnitte 12 erstrecken sich senkrecht zur n-Zone 5 und weisen eine Dicke zwischen 15 und 30 µm auf. Eine Breite des Hauptabschnitts 11 beträgt 1 mm. Die Nebenabschnitte 12 weisen eine Breite zwischen 100 und 500 µm auf und bilden über eine Länge von 10 bis 40 mm auf jeder Seite ein gitterartiges Raster mit einem Abstand von 3 bis 5 mm zueinander. Gruppen von Nebenabschnitten 12, die auf einer jeweiligen Seite des Hauptabschnitts 11 senkrecht in einer Line zum Hauptabschnitt 11 angeordnet sind, sind jeweils mittels eines Verbindungsabschnitts 13 mit dem Hauptabschnitt 11 verbunden. Ein solches Design kann auch als Fischflossenstruktur bezeichnet werden. Die Aufschlämmungsschicht wird im Schritt S312 getrocknet. Dies erfolgt bei 150 °C für 30 min. Anschließend wird die getrocknete Aufschlämmungsschicht im Schritt S313 einer Wärmebehandlung unterzogen. Dies erfolgt für eine Dauer von 10 bis 30 min bei 300 °C in einer Stickstoffatmosphäre.

Der Schritt S320 ist ein Bestrahlen der Passivierungsschicht 8 mit einem gepulsten Laser. Dazu wird ein Nanosekundenlaserstrahl mit einer Wellenlänge zwischen 500 und 550 nm, hier 532 nm, expandiert, geformt und durch einen zylindrischen Spiegel zu einer Strahlbreite zwischen 1 und 3 mm, hier zu einem bandförmigen Strahl von 2 x 30 mm, und einer Strahllänge zwischen 1 und 5 cm fokussiert. Mit einer Geschwindigkeit zwischen 0,1 und 0,5 mm·s⁻¹, hier 0,4 mm·s⁻¹, werden durch die Gateelektrode 10 kontaktierte Bereiche des Passivierungsschicht 8 durch den Laser bestrahlt. Es wird ein Laser mit einer Pulsweite von zwischen 6 und 18 ns, hier 12 ns, und einer Energiedichte von zwischen 100 und 300 mJ cm⁻², hier 150 mJ·cm⁻², verwendet. Dadurch wird eine flächenbezogene Wasserstoffkonzentration von wenigstens 2·10¹⁸ cm⁻² realisiert, wohingegen die flächenbezogene Wasserstoffkonzentration in übrigen Bereichen der Passivierungsschicht 8 unter 2·10¹⁶ cm⁻² liegt.

Gemäß einem weiteren Ausführungsbeispiel des Herstellungsverfahrens wird das PECVD im Schritt S222 für eine Dauer von 10 min durchgeführt, wobei die dünnste Stelle der Passivierungsschicht 8 eine Dicke von 900 Å und ihre dickste Stelle eine Dicke von 2800 Å aufweist.

Gemäß einem weiteren Ausführungsbeispiel des Herstellungsverfahrens wird das PECVD im Schritt S222 als Niederdruckverfahren durchgeführt. Dabei beträgt der Arbeitsdruck zwischen 5 und 10 mTorr.

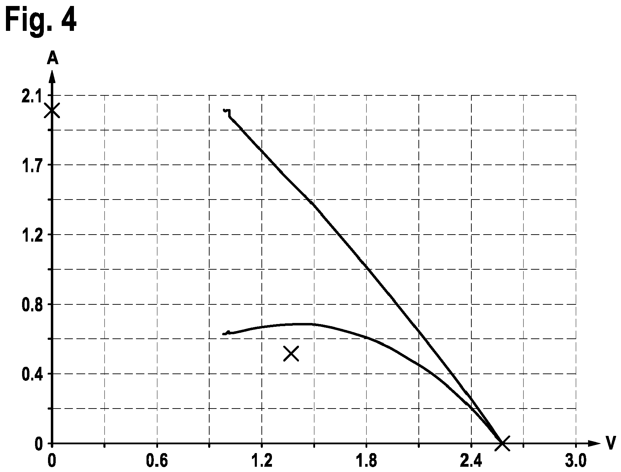

Fig. 4 ist eine experimentell ermittelte Strom-Spannungs-Kennlinie eines weiteren Ausführungsbeispiels der Anordnung, die mit dem zuvor beschriebenen Herstellungsverfahren hergestellt wurde und strukturell dem Ausführungsbeispiel der Anordnung 1 gemäß Fig. 1 und Fig. 2 entspricht. Die Solarzelle weist eine Fläche von 40,6 cm² auf. Es wurden folgende Kenngrößen bei einer externen Spannung von V_{L} = 4 V und einer Leistungsdichte der AM1,5-Bestrahlung von 100,662 mW·cm⁻² gemessen:

| | |
|---|---|
| Leerlaufspannung | V₀ = 2,58 V |
| Kurzschlussstrom | I₀ = 1,982 A |
| Maximale Ausgangsleistung | Pₘₐₓ = 1,593 W |
| Ausgangsstrom unter Last | Iₘₐₓ = 1,177 A |
| Ausgangsspannung unter Last | Vₘₐₓ = 1,370 V |
| Füllfaktor | FF = 31,1 % |
| Verluste durch Spannungsquelle | P_{L} = 0,16 W |
| Wirkungsgrad: | η = 39,23 % |

Im Rahmen weiterer Experimente hat sich auch gezeigt, dass ein im Schritt S222 gebildeter MQS-Übergang empfindlich auf die Temperatur während des PECVD-Prozesses reagiert. Ab ca. 300 °C wird die Selektion und Extraktion heißer Elektronen verringert und ab ca. 600 °C vollständig unterbunden.

## Patentansprüche

1. Solarzelle (2), umfassend
- ein Halbleitersubstrat (4) mit einer n-Zone (5) und einer p-Zone (6),
- eine n-zonenseitig auf dem Halbleitersubstrat (4) angeordnete Passivierungsschicht (8),
- eine Extraktionselektrode (9), welche die Passivierungsschicht (8) durchdringt und die n-Zone (5) kontaktiert und
- eine auf der Passivierungsschicht (8) angeordnete Gateelektrode (10), welche mit dem Halbleitersubstrat (4) und der Passivierungsschicht (8) einen Photoschalter ausbildet, der dazu eingerichtet ist, bei einer Bestrahlung der Passivierungsschicht (8) mit Licht (L) in einen nichtlinearen leitenden Zustand zu schalten, wenn zwischen der Gateelektrode (10) und der Extraktionselektrode (9) eine externe Spannung angelegt wird.

2. Solarzelle nach Anspruch 1, wobei der Photoschalter dazu eingerichtet ist, seinen flächenbezogenen Widerstand beim Übergang von einem nicht mit Licht (L) bestrahlten Zustand in den nichtlinear leitenden Zustand um einen Faktor zwischen 300 und 4000 zu verringern.

3. Solarzelle nach Anspruch 1 oder 2, wobei die Gateelektrode (10) einen die Passivierungsschicht (8) kontaktierenden Hauptabschnitt (11) und ein oder mehrere vom Hauptabschnitt (11) abstehende, die Passivierungsschicht (8) nicht kontaktierende Verbindungsabschnitte (13) aufweist, wobei von dem oder einem jeweiligen Verbindungsabschnitt (13) ein oder mehrere die Passivierungsschicht (8) kontaktierende Nebenabschnitte (12) abstehen.

4. Solarzelle nach Anspruch 3, wobei die Verbindungabschnitte (13) an zwei gegenüberliegenden Seiten des Hauptabschnitts (10) ausgebildet sind.

5. Solarzelle nach einem der vorhergehenden Ansprüche, wobei das Halbleitersubstrat (4) eine auf der n-Zone (5) ausgebildete Isolierschicht (7) aufweist.

6. Solarzelle nach einem der vorhergehenden Ansprüche, wobei die Passivierungsschicht (8) als hydrogenisierte SiNx-Schicht ausgebildet ist.

7. Solarzelle nach Anspruch 6, wobei ein flächenbezogener Wasserstoffgehalt in Bereichen der SiNx-Schicht, die zwischen einem von der Gateelektrode (10) kontaktierten Bereich und dem Halbleitersubstrat (4) liegen, wenigstens um den Faktor 10, bevorzugt um den Faktor 100, höher ist, als in übrigen Bereichen der SiNx-Schicht.

8. Solarzelle nach einem der vorhergehenden Ansprüche, wobei die Passivierungsschicht (8) auf einer vom Halbleitersubstrat (4) abgewandten Seite konkav ausgebildet ist.

9. Verfahren zur Herstellung einer Solarzelle (2), umfassend folgende Schritte:
- Bereitstellen eines Halbleitersubstrats (4) mit einer n-Zone (5) und einer p-Zone (6);
- Ausbilden einer Passivierungsschicht (8) und einer Extraktionselektrode (9), welche die Passivierungsschicht (8) durchdringt und die n-Zone (5) kontaktiert, auf dem Halbleitersubstrat (4); und
- Ausbilden eines durch die Passivierungsschicht (8), einer auf der Passivierungsschicht (8) anordneten Gateelektrode (10) und dem Halbleitersubstrat (4) gebildeten Photoschalters, der dazu eingerichtet ist, bei einer Bestrahlung der Passivierungsschicht (8) mit Licht (L) in einen nichtlinearen leitenden Zustand zu schalten, wenn zwischen der Gateelektrode (10) und der Extraktionselektrode (9) eine externe Spannung angelegt wird.

10. Verfahren nach Anspruch 9, wobei das Ausbilden des Photoschalters ein Bestrahlen der Passivierungsschicht (8) mittels eines gepulsten Lasers umfasst.

11. Verfahren nach Anspruch 10, wobei ein Laser mit
- einer Strahlbreite zwischen 1 und 3 mm und/oder
- einer Strahllänge zwischen 1 und 5 cm und/oder
- einer rechteckigen Strahlform und/oder
- einer Wellenlänge zwischen 500 und 550 nm und/oder
- einer Energiedichte zwischen 100 und 300 mJ/cm² und/oder
- einer Pulsweite zwischen 6 und 18 ns und/oder
- einer Abtastgeschwindigkeit zwischen 0,1 und 0,5 mm/s
verwendet wird.

12. Verfahren nach einem der Ansprüche 9 bis 11, wobei die Passivierungsschicht (8) als hydrogenisierte SiNx-Schicht ausgebildet wird.

13. Verfahren nach einem der Ansprüche 9 bis 12, wobei das Ausbilden Passivierungsschicht (8) durch plasmaunterstützte chemische Gasphasenabscheidung erfolgt.

14. Verfahren nach Anspruch 13, wobei während der plasmaunterstützten chemischen Gasphasenabscheidung
- stickstoffverdünntes Monosilan und Ammoniak als Arbeitsgase, insbesondere mit einem Strömungsverhältnis zwischen 1:2 und 1:5 verwendet, und/oder
- das Halbleitersubstrat auf 100 °C bis 300 °C erwärmt wird und/oder
- ein Arbeitsdruck zwischen 20 und 50 Pa oder zwischen 5 und 10 mTorr verwendet wird und/oder
- eine HF-Leistung zwischen 50 und 200 Watt
verwendet wird.

15. Verfahren zum Betreiben einer Solarzelle (2) nach einem der Ansprüche 1 bis 8 oder einer durch Verfahren nach einem der Ansprüche 9 bis 14 erhaltenen Solarzelle (2), wobei zwischen der Gateelektrode (10) und Extraktionselektrode (9) eine, insbesondere positive, externe Spannung angelegt wird.

16. Anordnung (1) mit einer Solarzelle (2) nach einem der Ansprüche 1 bis 8 oder einer durch ein Verfahren nach einem der Ansprüche 9 bis 14 erhaltenen Solarzelle (2) und mit einer Spannungsquelle (3), die zur Bereitstellung der externen Spannung an die Gateelektrode (10) und an die Extraktionselektrode (9) angeschlossen ist.
